# EUROPÄISCHE PATENTSCHRIFT

(11) **EP 2 544 214 B1**
(45) Veröffentlichungstag und Bekanntmachung des Hinweises auf die Patenterteilung: **06.09.2017**
(21) Anmeldenummer: 12004906.9
(22) Anmeldetag: 02.07.2012
(51) Int. Cl.: H01J 37/09, H01J 37/26, H01J 37/147

(54) **Integrierbare Magnetfeldkompensation für den Einsatz an Raster- und Transmissionselektronenmikroskopen**
Integrating magnetic field compensation for use in scanning and transmission electron microscopes
Compensation de champ magnétique intégrable pour utilisation sur un microscope électronique à transmission et à balayage

(30) Priorität: 04.07.2011 DE 102011106433
(43) Veröffentlichungstag der Anmeldung: 09.01.2013
(73) Patentinhaber: Integrated Dynamics Engineering GmbH, 65479 Raunheim (DE)
(72) Erfinder: Kropp, Peter A., Dr., 55130 Mainz (DE)
(74) Vertreter: Herden, Andreas F.

(56) Entgegenhaltungen:
- WO-A1-2010/029725
- DE-A1-102009 009 562
- JP-A- 2003 173 755
- JP-A- 2008 053 121
- JP-B2- 3 261 018
- US-A- 5 057 689
- US-A1- 2002 117 969
- US-A1- 2003 038 243
- US-A1- 2003 218 427

## Beschreibung

### Beschreibung der Erfindung

Die vorliegende Erfindung betrifft eine Anordnung und ein Verfahren zum Abbilden, Untersuchen und/oder Bearbeiten einer Probe mittels Elektronen mit einem Transmissions- oder Rasterelektronenmikroskop und mit einem System zur Magnetfeldkompensation.

### Hintergrund der Erfindung

Magnetfeldkompensationen nach dem Feedback-Control-Prinzip sind bekannt. Dabei wird ein Raumvolumen, das hier auch als Kompensationsvolumen bezeichnet wird, durch destruktive Interferenz quasi oder im Wesentlichen feldfrei gemacht. Zu diesem Zweck nimmt ein Feedback-Sensor das magnetische Störfeld, zum Beispiel das Erdmagnetfeld, in der Nähe des zu schützenden Objekts auf und leitet dieses Signal an eine Steuereinheit. Basierend auf den Sensorsignalen errechnet die Steuereinheit einen Kompensationsstrom, welcher auf die Kompensationsspulen geleitet wird. Diese erzeugen dann ein Feld, welches sich im Idealfall mit dem Störfeld destruktiv so überlagert, dass die Amplitude der Störung minimiert ist oder zumindest wesentlich reduziert ist.

Insbesondere die Geräte, die mit beschleunigten Elektronen arbeiten, beispielsweise Raster- und/oder Transmissionselektronenmikroskope, leiden unter elektromagnetischen Störungen, weil sie direkt die Flugbahn der zur Bildgebung benötigten Elektronen und damit die Qualität der Ergebnisse negativ beeinflussen.

Typische Installationen für solche Geräte beinhalten einen Kompensationsaufbau in Form eines dreiachsigen Doppelspulensystems, die meist als Würfel ausgeführt sind. Dabei sind die sich jeweils gegenüberliegenden Seiten des Würfels als Spulenpaar für die Generierung eines möglichst homogenen Kompensationsfeldes eingesetzt.

Im Inneren dieses durch die Spulen umschlossenen Volumens wird dann das zu schützende Gerät aufgestellt, so dass es im quasi feldfreien Raum betrieben werden kann.

Ein weiterer Stand der Technik sieht vor, anstatt des jeweils einen Spulenpaars pro Raumrichtung jeweils nur eine Einfachspule pro Raumrichtung bzw. pro Achse vorzusehen. Das Kompensationsfeld ist dann deutlich inhomogener, reicht in der Regel jedoch aus und spart drei Spulenkonstruktionen ein.

Allen Konfigurationen im Stand der Technik sehen einen Sensor im Inneren des Volumens vor, weil die Regelung im Allgemeinen im Rückkopplungsverfahren arbeitet. Neben den auch am Boden zu verlegenden Kabeln, durch welche die Kompensationsspulen bereitgestellt bzw. gewickelt werden, befindet sich also auch noch ein Sensor in unmittelbarer Nähe des Gerätes. So ist durch die Konstruktion der Anordnung bedingt eine Beeinflussung der Bedienbarkeit des Geräts gegeben.

Das Dokument US 2003/218 427 A1 zeigt einen Plasmareaktor, in dessen Inneren Spulen vorhanden sind, um eine homogene Plasmaverteilung zu erreichen. Das Dokument US 2002/117 969 A1 zeigt ein Lithographiegerät, welches im Strahlgang Spulen zur Kompensation magnetischer Interferenzen aufweist. Das Dokument DE 10 2009 009 562 A1 zeigt ein Schwingungsisolationssystem mit einer Feed-forward-Regelung. Die Dokumente US 2003/038 243 A1 und JP 2003-173 755 A zeigen Lithographiegeräte mit einer aktiven Störfeldkompensation.

### Allgemeine Beschreibung der Erfindung

Vor diesem Hintergrund hat sich die vorliegende Erfindung zur Aufgabe gestellt, ein System und ein Verfahren zur Magnetfeldkompensation, insbesondere für Raster- und/oder Transmissionselektronenmikroskopen (REM bzw. TEM), bereitzustellen, welche die vorstehend beschriebenen Nachteile des Standes der Technik zumindest vermindern.

Dabei soll es insbesondere möglich sein, die Erfindung in bereits bestehende Regelungskonzepte integrieren zu können bzw. die bekannten Regelungskonzepte erweitern zu können.

Insbesondere soll hierbei Rücksicht genommen werden auf die besonderen Bedingungen bei der Bedienbarkeit der Geräte und auf die gerätespezifischen Eigenschaften.

Gelöst werden die genannten Aufgaben durch eine Anordnung und ein Verfahren zum Abbilden, Untersuchen und/oder Bearbeiten einer Probe, beispielsweise eines Wafers, mittels elektrisch geladener Teilchen, insbesondere Elektronen gemäß den unabhängigen Ansprüchen.

Vorteilhafte Ausführungsformen sind Gegenstand der jeweiligen Unteransprüche.

Allgemein kann die Erfindung dadurch beschrieben werden, dass das System zur Magnetfeldkompensation, insbesondere die Kompensationsspulen, so in das eigentliche Gerät bzw. die Anordnung integriert ist, dass die Bedienbarkeit der Anordnung nicht wesentlich beeinträchtigt ist.

Es wird dabei vorgeschlagen, eine Kammer, in der eine Probe angeordnet ist, beispielsweise eine Vakuumkammer, selbst und vorzugsweise allein als ein Kompensationsvolumen zu betrachten. Es wird hierbei insbesondere vorgeschlagen, das Kompensationsvolumen auf den sensitiven Punkt bzw. Bereich, beispielsweise von REM- und/oder TEM-Geräten, zu beziehen bzw. zu reduzieren. Denn es hat sich gezeigt, dass zum Beispiel ein Elektronenstrahl in einer Vakuumkammer, kurz nach einer letzten Fokussierung und/oder Filterung am empfindlichsten in Bezug auf die Bildqualität beeinflusst wird, wenn externe elektromagnetische Störungen einwirken.

Zunächst wird in der vorliegenden Anmeldung eine Anordnung beansprucht zum Abbilden, Untersuchen und/oder Bearbeiten einer Probe mittels elektrisch geladener Teilchen, umfassend
- eine Vorrichtung zum Bereitstellen von elektrisch geladenen Teilchen und zum Führen der elektrisch geladenen Teilchen auf eine in einer Kammer angeordnete Probe,
- wobei die Kammer einen Probehalter umfasst, auf welchem eine Probe so positionierbar ist, dass diese mittels der durch die Vorrichtung bereitstellbaren Teilchen abgebildet, untersucht und/oder bearbeitet werden kann, und
- ein System zur Magnetfeldkompensation in zumindest einer Raumrichtung mit wenigstens einer Kompensationsspule, welche durch wenigstens eine Windung eines Leiters bereitgestellt ist, so dass in einem durch die wenigstens eine Kompensationsspule erzeugten Kompensationsvolumen innerhalb der Kammer ein Magnetfeld so bereit gestellt wird, dass entlang eines Abschnitts einer Flugbahn der elektrisch geladenen Teilchen ein magnetisches Störfeld kompensiert wird, wobei wenigstens eine Wand der Kammer zumindest abschnittsweise einen Aufnahmebereich für zumindest einen Abschnitt der Kompensationsspule aufweist.

Die Vorrichtung zum Bereitstellen der elektrisch geladenen Teilchen wird in einer bevorzugten Ausführungsform als ein Elektronenmikroskop, z.B. als Rasterelektronenmikroskop und/oder Transmissionselektronenmikroskop, bereitgestellt. In einer weiteren Ausführungsform wird die Vorrichtung zum Bereitstellen der elektrisch geladenen Teilchen als ein Lithographie-Gerät bereitgestellt.

Die Kammer ist vorzugsweise als Vakuumkammer ausgeführt. Die Kompensationsspule, insbesondere deren Leiter, ist der Wand der Kammer zugeordnet. Unter einer Wand werden die seitlichen Wände, der Boden und der Deckel der Kammer verstanden.
In einer Ausführungsform der Erfindung wird der Abschnitt zur Aufnahme des Leiters bzw. der Aufnahmebereich durch eine Außenseite und/oder eine Innenseite der Kammerwand bereitgestellt. Die Kompensationsspule, insbesondere deren Leiter, ist zumindest abschnittsweise auf der Außenseite und/oder der Innenseite der Kammerwand angeordnet. Zum Beispiel wird die wenigstens eine Windung des Leiters entlang der Wand der Kammer verlegt.

In einer alternativen oder ergänzenden Ausführungsform wird der Aufnahmebereich bzw. der Abschnitt zur Aufnahme der Kompensationsspule, insbesondere des Leiters, durch eine zumindest sich abschnittsweise in der Kammerwand erstreckende Ausnehmung bereitgestellt.

Die Ausnehmung kann zum Beispiel als eine Art Graben oder Vertiefung in der Außenseite und/oder der Innenseite der Kammerwand bereitgestellt werden. In dieser Variante der Erfindung liegt eine Art offene Ausnehmung vor, wobei der Leiter bzw. die Kompensationsspule abschnittsweise oder vollständig versenkt in der Ausnehmung liegen kann.

Vorzugsweise wird die Ausnehmung jedoch als ein Hohlraum in der Kammerwand ausgeführt. In der Variante liegt eine Art geschlossene Ausnehmung, zum Beispiel eine Art Röhre, vor, in welcher der Leiter bzw. die Kompensationsspule abschnittsweise oder vollständig eingeschoben werden kann.

Die Kompensationsspule, insbesondere der Leiter, kann mit der Kammer unmittelbar verbunden sein, zum Beispiel indem der Leiter auf die Kammerwand aufgelegt und/oder in die Kammerwand eingeführt wird.

Die Kompensationsspule, insbesondere der Leiter, kann mit der Kammer aber auch mittelbar, zum Beispiel über einen Rahmen, auf welchem der Leiter zum Bereitstellen der Windungen ausgewickelt wird, verbunden sein.

Es kann ausreichend sein, das magnetische Störfeld in nur einer Ebene senkrecht zur Flug- bzw. Strahlrichtung der elektrisch geladenen Teilchen, zu kompensieren. Diese Ebene wird im Allgemeinen durch die horizontale Ebene bereitgestellt.

Um jedoch das magnetische Störfeld im Wesentlichen vollständig kompensieren zu können, wird das Störfeld vorzugsweise sowohl in der horizontalen Ebene als auch entlang der Vertikalen kompensiert. Die Koordinaten X und Y definieren die horizontale Ebene und die Koordinate Z die Vertikale dazu.

In einer Ausführungsform wird jeder Raumrichtung X, Y und Z wenigstens eine Kompensationsspule zugeordnet, so dass ein magnetisches Störfeld in den drei bzw. in allen Raumrichtungen X, Y und Z kompensierbar ist.

Es kann hierbei möglich sein, jeder Raumrichtung X, Y und Z oder wenigstens einer Raumrichtung X, Y oder Z nur eine einzelne Kompensationsspule zuzuordnen.

Jeder einzelnen Kompensationsspule kann auch wenigstens eine weitere Spule, vorzugsweise auf der gleichen Achse, zugeordnet sein. Es wird ein Kompensationsspulenpaar gebildet. In einer Ausführungsform ist dabei jeder Raumrichtung wenigstens ein Kompensationsspulenpaar zugeordnet, so dass ein magnetisches Störfeld in allen Raumrichtungen X, Y und Z kompensierbar ist.

Das System zur Magnetfeldkompensation umfasst, neben der wenigstens einen Kompensationsspule zum Generieren eines magnetischen Kompensationsfeldes, noch wenigstens einen Sensor zum Erfassen bzw. Messen eines magnetischen Störfeldes, wenigstens eine Stromversorgung für die wenigstens eine Kompensationsspule und eine Einrichtung zum Steuern und/oder Regeln des Stromes in der wenigstens einen Kompensationsspule in Abhängigkeit vom erfassten bzw. gemessenen magnetischen Störfeld.

Das Kompensationsspulenpaar kann derart angeschlossen und/oder ansteuerbar sein, dass lediglich eine einzelne Kompensationsspule des Kompensationsspulenpaars mit Strom versorgt werden kann.

Durch die Kompensationsspule bzw. das von ihr generierte Kompensationsfeld wird ein Kompensationsvolumen, in dem magnetische Störfeld im Wesentlichen kompensiert wird, bereitgestellt oder definiert. Das Kompensationsvolumen beschreibt den Bereich des durch die Kompensationsspule erzeugten magnetischen Feldes, welcher geeignet ist zur Kompensation eines magnetischen Störfeldes vorzugsweise ausreichend homogen ist.

Erfindungsgemäß wird vorgeschlagen, das bereitgestellte Kompensationsvolumen insbesondere auf das minimal Notwendige zu beschränken oder zumindest zu reduzieren auf einen Bereich, um den sensitiven Punkt von REM/TEM-Geräten herum. Die Reduzierung des Kompensationsvolumens wird dabei erfindungsgemäß insbesondere dadurch erreicht, dass die wenigstens eine Kompensationsspule der Kammer zugeordnet wird. Es wird hierbei vorgeschlagen, die Kammer, in der die Probe angeordnet ist, selbst und vorzugsweise allein als Kompensationsvolumen zu betrachten. Somit wird nicht mehr, die gesamte Anordnung als Kompensationsvolumen betrachtet, wie es im Stand der Technik bisher üblich ist. Das Kompensationsvolumen wird erfindungsgemäß auf einen Bereich innerhalb der Kammer beschränkt.

Im Rahmen der Erfindung liegt auch ein Verfahren zum Abbilden, Untersuchen und/oder Bearbeiten einer Probe mittels elektrisch geladener Teilchen, indem die elektrisch geladenen Teilchen von einer Vorrichtung bereitgestellt und auf eine in einer Kammer angeordnete Probe geführt werden,
wobei wenigstens eine Wand der Kammer zumindest abschnittsweise einen Aufnahmebereich für zumindest einen Abschnitt einer Kompensationsspule aufweist, und wobei in einem durch wenigstens eine Kompensationsspule erzeugten Kompensationsvolumen ein Magnetfeld so bereitgestellt wird, dass entlang eines Abschnitts einer Flugbahn der Teilchen ein magnetisches Störfeld kompensierbar ist, wobei
das Kompensationsvolumen in einem Bereich nach einer Fokussierung und/oder Filterung, der elektrisch geladenen Teilchen bereitgestellt wird und wobei das Kompensationsvolumen auf einen Bereich innerhalb der Kammer (20) beschränkt wird. Das erfindungsgemäße Verfahren ist insbesondere ausführbar mittels der oben genannten erfindungsgemäßen Anordnung. Die erfindungsgemäße Anordnung ist insbesondere ausgebildet zur Ausführung des erfindungsgemäßen Verfahrens.

Das durch die Spulen bereitgestellte Kompensationsvolumen umfasst hierbei einen Wechselwirkungsbereich zwischen den elektrisch geladenen Teilchen und der Probe. Insbesondere wird das Kompensationsvolumen im Wesentlichen auf einen Bereich beschränkt, in dem beispielsweise die Flugbahn der Teilchen und/oder die Form des Teilchenstrahls von außen nicht mehr gesteuert werden soll.

Um ein möglichst präzises Abbilden, Untersuchen und/oder Bearbeiten einer Probe zu ermöglichen, wird die Anordnung im Allgemeinen schwingungsisoliert gelagert.

Unter einer Schwingungsisolation wird verstanden, dass den störenden Bewegungen oder Schwingungen, die auf das System einwirken, entgegengewirkt werden soll. Im Idealfall wird die Bewegung oder die Schwingung kompensiert. Dies erfolgt vorzugsweise in allen sechs Freiheitsgraden der Bewegung. Daher wird dies oft auch als Schwingungskompensation bezeichnet.

Im Bereich der vorliegenden Erfindung liegt auch ein Schwingungsisolationssystem mit wenigstens einer schwingungsisoliert gelagerten Anordnung gemäß der vorliegenden Erfindung. Es kann als aktives und/oder passives Schwingungsisolationssystem bereitgestellt werden.

Ein passives Schwingungsisolationssystem ist gekennzeichnet durch eine "einfache" Lagerung mit möglichst geringer mechanischer Steifigkeit, um die Übertragung von externen Schwingungen auf die zu isolierende Last zu reduzieren. Ein Luftlager und ein Polymer-Federelement zum Lagern sind zwei Beispiele für ein passives Schwingungsisolationssystem.

Gegenüber einer passiven Schwingungsisolation, die durch eine Art Dämpfung der Schwingung oder eine Art "isolierte" Lagerung der Last gekennzeichnet ist, ist eine aktive Schwingungsisolation dadurch gekennzeichnet, dass die Schwingung aktiv kompensiert wird. Eine Bewegung, welche durch eine Schwingung induziert wird, wird durch eine entsprechende Gegenbewegung kompensiert. Zum Beispiel wird einer durch eine Schwingung induzierten Beschleunigung der Masse eine dem Betrag nach gleich große Beschleunigung, jedoch mit entgegengesetzten Vorzeichen entgegengesetzt. Die resultierende Gesamtbeschleunigung der Last ist gleich Null. Die Last verharrt in Ruhe bzw. der gewünschten Lage.

Aktive Schwingungsisolationssysteme weisen daher, optional zusammen mit einer Lagerung mit möglichst mechanisch geringer Steifigkeit, zusätzlich ein Regelsystem auf, das eine Regeleinrichtung sowie Sensoren und Aktoren umfasst, mit denen gezielt von außen in das System eindringenden Schwingungen entgegengewirkt wird. Die Sensoren erfassen Bewegungen der zu lagernden Last. Über die Regeleinrichtung werden Kompensationssignale generiert, mit welchen die Aktoren angesteuert und so Kompensationsbewegungen generiert werden. Dabei gibt es die Möglichkeit, digitale oder analoge Regelungsstrecken zu verwenden oder aber auch beide zusammen, sogenannte hybride Regelungsstrecken.

Die vorliegende Erfindung wird anhand der nachfolgenden Ausführungsbeispiele im Einzelnen erläutert. Hierzu wird auf die beiliegenden Zeichnungen Bezug genommen. Die gleichen Bezugszeichen in den einzelnen Zeichnungen beziehen sich auf die gleichen Teile.
Fig. 1.a bis 1.c zeigen schematisch ein beispielhaftes Rasterelektronenmikroskop in einem Querschnitt (Fig. 1.a), die zugehörige Strahlführung (Fig. 1.b) und ein durch ein Spulenpaar erzeugten magnetisches Kompensationsfeld (Fig. 1.c).
Fig. 2.a und 2.b zeigen schematisch zwei beispielhafte Ausführungsformen zur Positionen der Kompensationsspulen an den Wänden einer Vakuumkammer.
Fig. 3.a und 3.b zeigen schematisch den Verlauf eines magnetischen Kompensationsfeldes, das durch eine einzelne Kompensationsspule bereitgestellt wird, in einer ebenen Darstellung zusammen mit der Anordnung (Fig. 3.a) und in einer räumlichen Darstellung (Fig. 3.b).
Fig. 4.a und 4.b zeigen schematisch den Verlauf eines magnetischen Kompensationsfeldes, das durch ein Paar von Kompensationsspulen bereitgestellt wird, in einer ebenen Darstellung zusammen mit der Anordnung (Fig. 4.a) und in einer räumlichen Darstellung (Fig. 4.b).
Fig. 5 zeigt schematisch ein beispielhaftes aktives Schwingungsisolationssystem mit einer schwingungsisoliert gelagerten erfindungsgemäßen Anordnung.

### Detaillierte Beschreibung der Erfindung

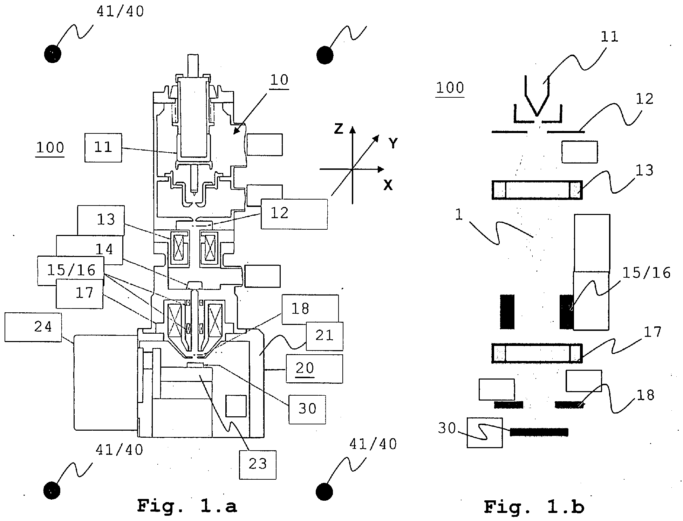

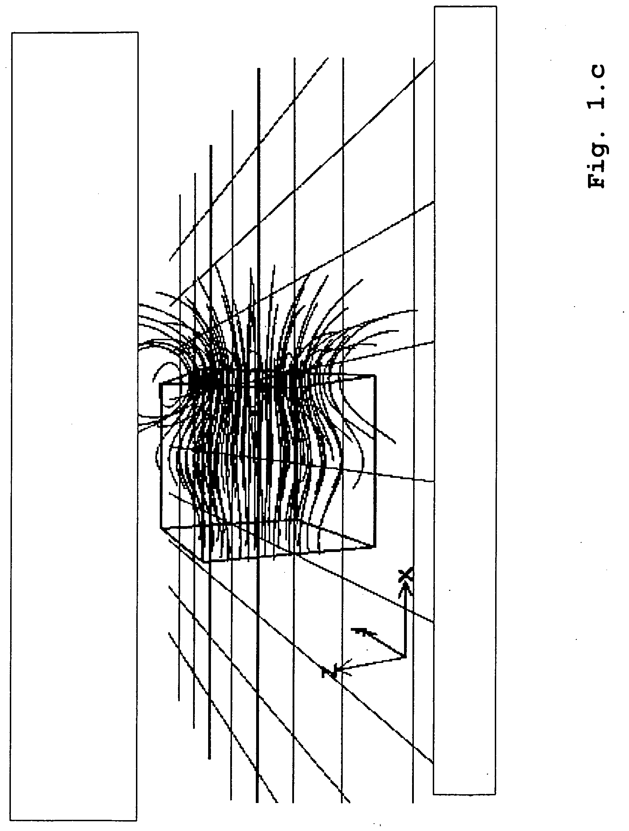

Die vorliegende Erfindung wird nachfolgend an dem Beispiel eines Rasterelektronenmikroskops 10 illustriert. Figur 1.a zeigt dazu den Querschnitt des Rasterelektronenmikroskops 10. Die Figur 1.b zeigt eine zugehörige Strahlführung der Elektronen 1. Die Funktion wird nur kurz skizziert: Die Elektronen 1 als elektrisch geladene Teilchen werden mittels einer Elektronenkanone 11 erzeugt. Durch Anlegen einer Extraktions- und einer Beschleunigungsspannung werden die Elektronen 1 auf die Probe 30 geführt. Im Strahlverlauf sind eine Vielzahl an Fokussierungseinrichtungen und/oder Ablenkeinrichtungen und/oder Blenden angeordnet, um die Flugbahn und/oder die Strahlform der Elektronen 1 und/oder die Abbildungseigenschaften entsprechend einstellen zu können.

Beispielhaft sind hierzu vorgesehen eine erste Blende 12 zur Strahlüberwachung, eine Kondensorlinse 13, eine erste und eine zweite Ablenkeinrichtung 15 und 16, insbesondere zum Rastern der Probe 30, eine Objektivlinse 17 sowie eine Objektivblende 18 als letzte Blende vor der Probe 30, die vorzugsweise beweglich angeordnet ist zum Rastern der Probe 30. Ein Ventil 14 ist zudem im Strahlverlauf angeordnet.

Die Probe 30 ist in einer Kammer 20 auf bzw. an einem Probenhalter 23 angeordnet. Die Position der Probe 30 bzw. des Probenhalters 23 relativ zum Elektronenstrahl 1 kann zum Beispiel durch einen Manipulator 24 verändert werden.

Die Anordnung 100 umfasst das Elektronenmikroskop 10 und die Kammer 20. Im Inneren des Rasterelektronenmikroskops 10 und im Inneren der Kammer 20 ist jeweils ein Vakuum angelegt. Die Elektronen 1 treffen auf die Probe 30 und lösen dort Sekundärelektronen aus. Diese erlauben einen Rückschluss auf die Eigenschaften der zu untersuchenden Probe 30. Über ein Rastern der Probe 30 kann diese Punkt für Punkt untersucht werden. Beispielsweise können die rückgestreuten Elektronen erfasst werden mittels eines nicht gezeigten Detektors und dann untersucht werden.

Zusätzlich ist sind hier noch zwei Kompensationsspulen 41 eingezeichnet. Diese zwei Spulen 41 bilden zusammen ein Kompensationsspulenpaar, um ein magnetisches Störfeld, hier in der Blattebene X-Z, zu kompensieren. Vorzugsweise ist für alle drei Raumrichtungen X, Y und Z jeweils ein Kompensationsspulenpaar vorgesehen. Eine Kompensationsspule 41 wird durch wenigstens eine Windung eines Leiters bereitgestellt. Die Kompensationsspulen 41 sind Bestandteil eines Systems 40 zur Magnetfeldkompensation. Das System 40 ist wiederum ein Bestandteil der Anordnung 100.

Die Kompensationsspulen 41 erstrecken sich hier über die gesamte Anordnung 100. Die dargestellte Anordnung 100 ist eine aus dem Stand der Technik bekannte Anordnung 100. Es wird versucht, das gesamte durch die Kompensationsspulen 41 erfasste Raumvolumen durch destruktive Interferenz quasi feldfrei zu machen. Die gesamte Anordnung 100 wird als Kompensationsvolumen betrachtet. Insbesondere durch die großen Abmessungen der Kompensationsspulen 41 ist eine Beeinflussung der Bedienbarkeit der Anordnung 100 gegeben. Figur 1.c zeigt das magnetische Kompensationsfeld für das gesamte Raumvolumen entlang der X-Achse.

Erfindungsgemäß wird angeregt, das Kompensationsvolumen zu reduzieren auf den sensitivsten Bereich der Anordnung 100. Es hat sich gezeigt, dass der Elektronenstrahl 1 in der Vakuumkammer 20 der Geräte, insbesondere kurz nach der letzten Fokussierung und/oder Filterung, insbesondere durch die Objektivlinse 17 und/oder die Objektivblende 18, am empfindlichsten in Bezug auf die Bildqualität beeinflusst wird, wenn externe elektromagnetische Störungen einwirken.

Das durch die Spulen 41 erzeugte Kompensationsvolumen wird im Wesentlichen nur bereitgestellt in dem Volumen zwischen der Objektivlinse 17 oder der letzen Blende 18 und einer Oberseite der Probe 30, auf welche der Elektronenstrahl 1 auftritt. Das bereitgestellte Kompensationsvolumen umfasst den Wechselwirkungsbereich des Elektronenstrahls 1 mit der Probe 30. Dazu wird die Spule 41 oder zumindest wenigstens ein Abschnitt einer Windung des Leiters der Wand 21 der Kammer 20 zugeordnet. Es wird in und/oder an der Wand 21 der Kammer 20 zumindest abschnittsweise ein Aufnahmebereich für die Spule 41, insbesondere den Leiter, bereitgestellt.

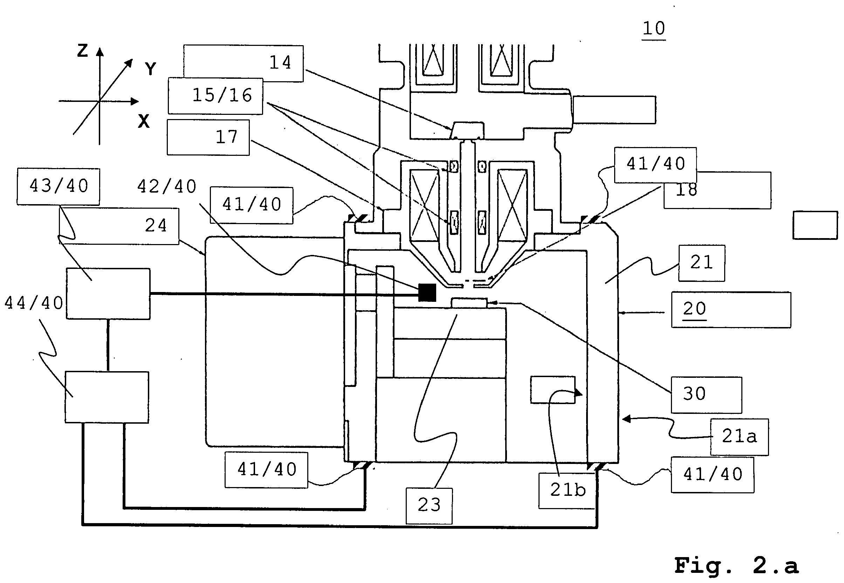

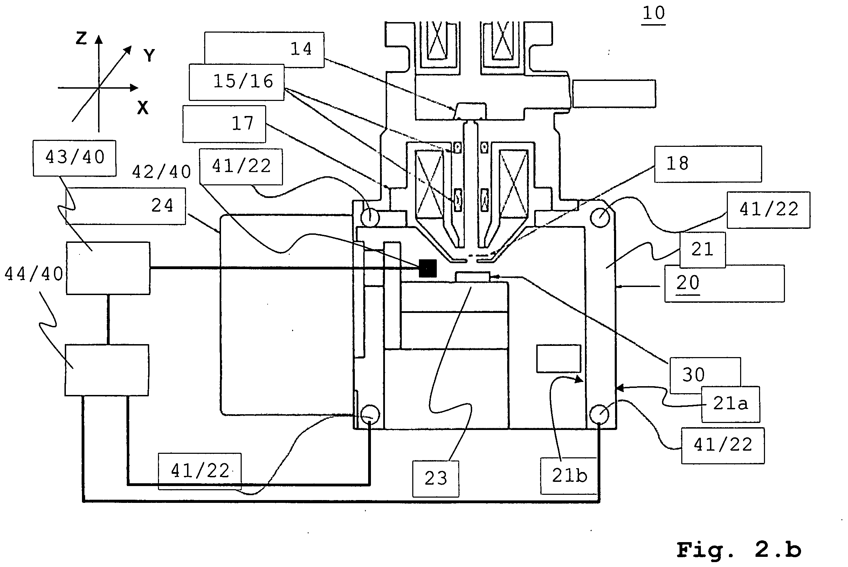

Die Figuren 2.a und 2.b illustrieren hierzu zwei Beispiele für den Aufnahmebereich in und/oder an der Kammerwand 21 zum Positionieren der Kompensationsspulen 41 an und/oder in den Wänden 21 einer Vakuumkammer 20.

In einer ersten Ausführungsform wird der Aufnahmebereich durch eine Außenseite 21a der Kammerwand 21 bereitgestellt. Die Spule 41 bzw. Der Leiter wird dazu entlang der Wand 21 der Kammer 20 verlegt. Das Kompensationsspulenkabel wird außen an der Vakuumkammer 20 entlang verlegt, vorzugsweise direkt auf der Außenwand 21a der Kammerwand 21. In Figur 2.a wird eine erste Spule 41 auf der oberen Außenseite 21a der Kammerwand 21 verlegt und eine zweite Spule 41 auf der unteren Außenseite 21b der Kammerwand 21 verlegt. Durch die erste Spule 41 und die zweite Spule 41 wird ein Spulenpaar gebildet.

In einer zweiten Ausführungsform wird der Aufnahmebereich durch einen Hohlraum 22 in der Kammerwand 21 erzeugt bzw. bereitgestellt. Es sind in der Wand 21 der Vakuumkammer 20 selbst Hohlräume zur Verlegung von Kompensationskabeln vorgesehen.

Eine Kompensationsspule 41 besitzt eine an die Größe der Kammer 20 angepasste Größe. Im Allgemeinen besitzt dabei die wenigstens eine Kompensationsspule 41 einen mittleren Durchmesser von kleiner als 100 cm, bevorzugt von kleiner als 50 cm, besonders bevorzugt von kleiner als 30 cm.

In beiden Figuren 2.a und 2.b sind zusätzlich ein Sensor 42 zum Erfassen oder Messen des magnetischen Feldes im Inneren der Kammer 20, eine Stromversorgung 44 für die Spulen 41 sowie eine Reglereinheit 43 zum Regeln und/oder Steuern des Spulenstroms eingezeichnet. In Abhängigkeit von dem gemessen Magnetfeld wird der Spulenstrom und somit das durch die Spulen 41 erzeugte magnetische Kompensationsfeld geregelt. Das System 40 zur Magnetfeldkompensation wird gebildet durch die Kompensationsspulen 41, den Sensor 42, die Reglereinheit 43 und die Stromversorgung 44.

In beiden Konfigurationen besteht die Möglichkeit, den Betrieb von Spulenpaaren sowie die Ansteuerung von nur einer einzelnen Spule 41 je Raumrichtung zu ermöglichen. Es kann zum Beispiel durch eine dynamische Konfigurierbarkeit in der Reglereinheit realisiert sein. Der entsprechende Betriebsmodus kann ausgewählt werden. Dieser richtet sich nach den speziellen Gegebenheiten am Gerät und die dafür notwendige Kompensationsfeldbeschaffenheit.

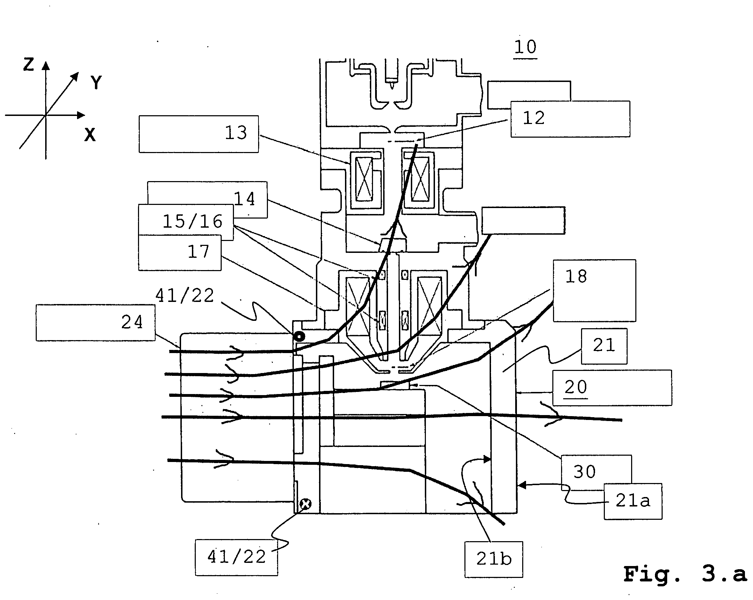

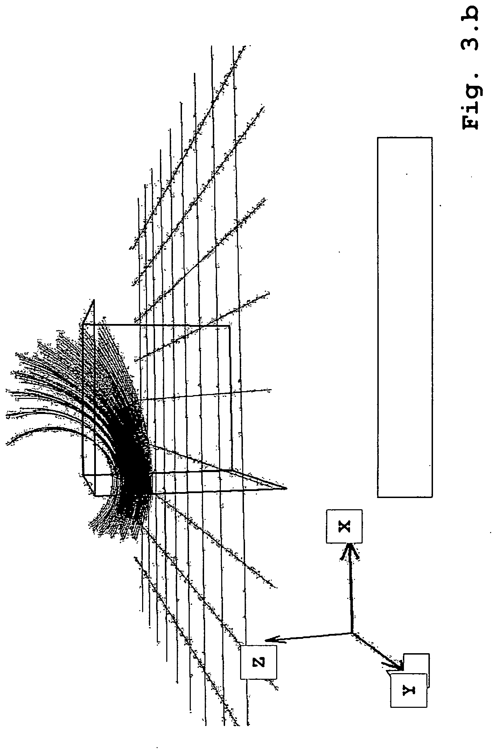

Eine einzelne Spule 41 erzeugt ein recht inhomogenes Feld. Es strahlt von der horizontalen Richtung abweichend noch oberhalb der Vakuumkammer 20 in vertikaler Richtung Z ab. Dies kann für Geräte, die in Z-Richtung weniger empfindlich sind, die bessere Alternative sein als ein Spulenpaar. Dazu zeigen die Figuren 3.a und 3.b den Verlauf des magnetischen Kompensationsfeldes, welches nur durch eine einzelne Kompensationsspule 41 bereitgestellt ist.

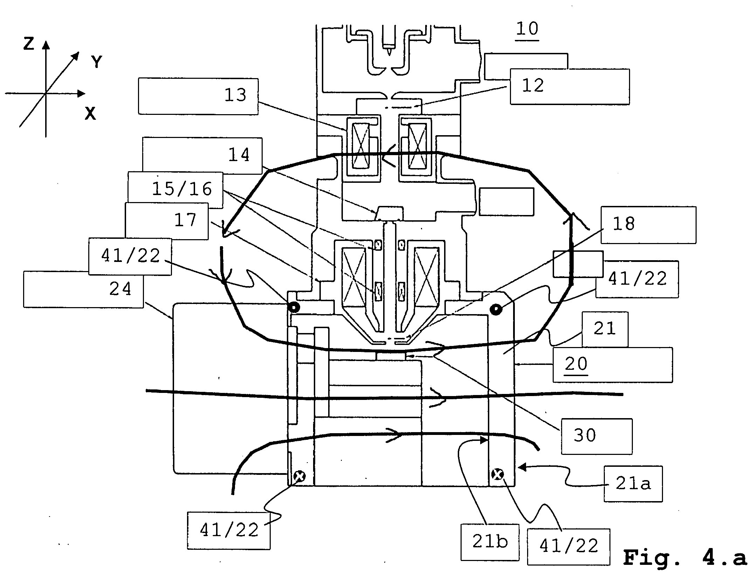

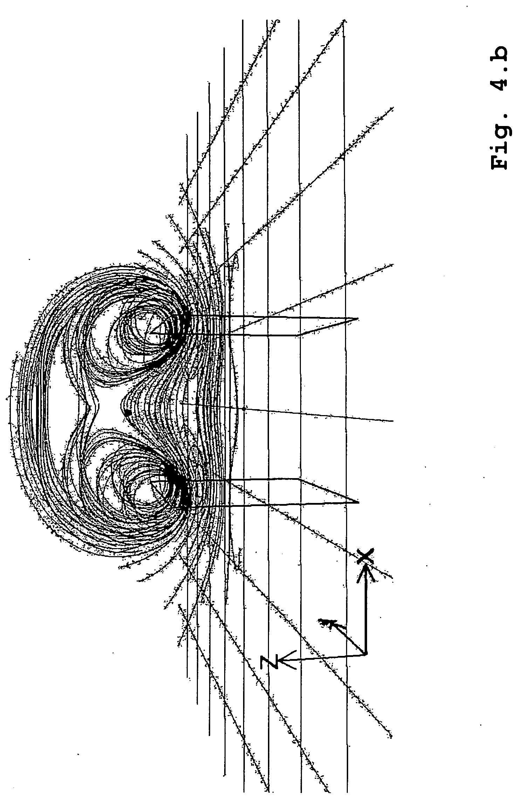

Dagegen zeigen die Figuren 4.a und 4.b den Verlauf eines magnetischen Kompensationsfeldes, welches durch ein Kompensationsspulenpaar bereitgestellt ist. Ein Spulenpaar macht zwar ein homogenes Feld. Es kehrt aber seine Richtung oberhalb der Vakuumkammer 20 um, wie ein Dipolfeld. Da davon auszugehen ist, dass die externe Störung über diesen kleinen Raumbereich gleichförmig ist, würde hier eine Verstärkung der externen Störung stattfinden. Es hängt vom Gerät selbst ab, ob oberhalb, vorzugsweise etwa zweifacher Vakuumkammerhöhe, dieser Effekt relevant ist oder nicht. Denn eine letzte Fokussierung und/oder Filterung findet kurz nach dem Eintritt in die Vakuumkammer 20 statt. Zudem hat die Amplitude des Dipolfeldes in einem Bereich oberhalb und zwischen den beiden Wirbeln ein Minimum. Schließlich ist die Amplitude dann auch im weiteren Fernfeld deutlich reduziert.

Es hängt vom Einzelfall ab, welche Ansteuerung ausgewählt werden soll. Die Auswahl der Ansteuerung kann zum Beispiel durch eine konfigurierbare Software erfolgen. Vorzugsweise erfolgt die Magnetfeldkompensationen nach dem Prinzip der Rückkopplungsregelung ("feedback control"). Die Regelung 43 ist darauf angewiesen, Sensorsignale zu bekommen, welche proportional zu dem magnetischen Störfeld sind. Dazu wird ein Sensor 42 in dem Kompensationsvolumen bzw. in dem Wechselwirkungsbereich zwischen den Elektronen 1 und der Probe 30 angeordnet (siehe dazu die Figuren 2.a und 2.b). Der Sensor 42 kann auch als Feedbacksensor bezeichnet sein.

Als Feedbacksensor 42 ist hier ein Magnetfeldsensor 42 in einer vakuumtauglichen Ausführung vorgesehen, zum Beispiel mit einer Keramik-Ummantelung. Vorzugsweise sollte der Sensor 42 möglichst klein ausgeführt sein. Insbesondere ist der Sensor 42 als ein chipbasierter Sensor 42 ausgeführt. Ein Beispiel für einen solchen Sensor 42 ist zum Beispiel in der Patentanmeldung DE 10 2009 024 268 A1 beschrieben. Ein Beispiel für eine Regelung 43 ist zum Beispiel in der Patentanmeldung EP 1 873 543 A1 beschrieben. Der Inhalt der beiden genannten Patentanmeldungen wird vollumfänglich in die vorliegende Anmeldung durch Bezugnahme inkorporiert.

Das Kompensationsvolumen liegt in einem Bereich von kleiner als 10⁶ cm³, bevorzugt von kleiner als 125000 cm³, besonders bevorzugt von kleiner als 27000 cm³. Beispiele für die zugehörigen Kantenlängen sind 100 cm * 100 cm * 100cm, 50 cm * 50 cm * 50cm und/oder 30 cm * 30 cm * 30cm. Wegen der geringen Dimensionen des Kompensationsvolumens und damit der kleinen Impedanz der dieses Volumen umschließenden Kompensationsspulen kann eine sehr große Bandbreite der Regelung bereitgestellt werden, zum Beispiel von > 50kHz. Darüber hinaus ist es insbesondere möglich, eine beliebig triviale elektronische Schaltung als Rückkopplungsregler 43 zu verwenden, da die Übertragungsfunktionen trivial sind.

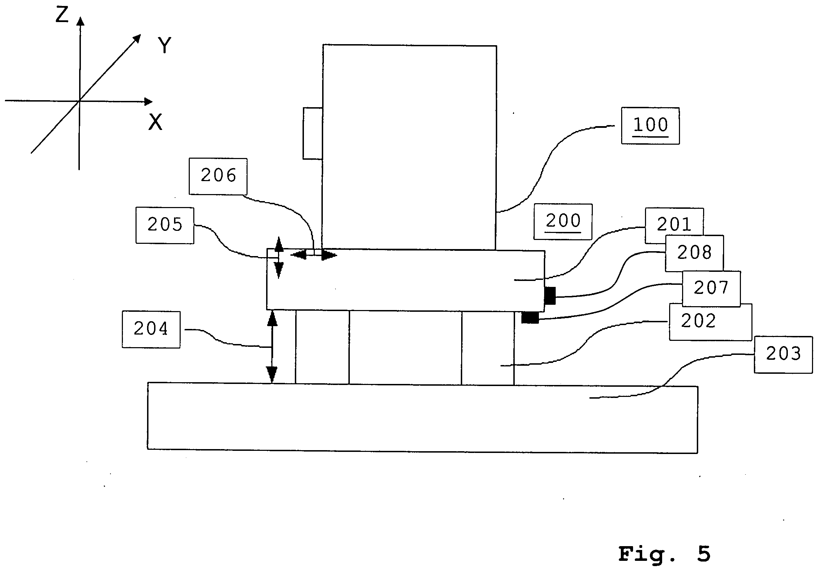

Abschließend zeigt Figur 5 die erfindungsgemäße Anordnung 100 mit einem ein Schwingungsisolationssystem 200, das hier beispielhaft als aktives Schwingungsisolationssystem 200 auf Basis pneumatischer Isolatoren 202 ausgeführt ist. Die Anordnung 100 als zu isolierende Masse ist mittels der pneumatischen Isolatoren 202 schwingungsisoliert von einem Boden 203 gelagert.

Zur aktiven Schwingungsisolation umfasst das System 200 in zum Beispiel vier pneumatische Isolatoren 202, eine Vielzahl an Aktoren 207 und 208 und eine Vielzahl an Sensoren 204, 205 und 206 als Schwingungssignalgeber. Über die Sensoren 204, 205 und 206 können Schwingungen oder allgemein Bewegungen der Basismasse 201 und der zu isolierenden Last 100 erfasst, in Signale umgewandelt und an ein Regelsystem, das hier nicht dargestellt ist, weitergegeben werden. Die Sensoren 204, 205 und 206 als Schwingungssignalgeber liefern somit die Schwingungen repräsentierende Sensorsignale.
Die pneumatischen Isolatoren 202 sind beispielsweise mit einem gegebenenfalls elektronisch steuerbaren Ventil ausgestattet. Damit bildet ein pneumatischer Isolator 202 zusammen mit dem Ventil einen Aktor mit vertikaler Wirkrichtung Z. Die Isolatoren 202 und die Aktoren 207 und 208 wirken den Schwingungen entgegen.

Aus Gründen einer verbesserten Übersicht sind in der Figur nur ein Teil der Komponenten eingezeichnet. Die Sensoren 204, 205 und 206 und die Aktoren 207 und 208 sind in dem dargestellten Beispiel nur für zwei Freiheitsgrade X und Z dargestellt.
Die Sensoren sind beispielsweise Geschwindigkeitssensoren, Beschleunigungssensoren oder/und Positionssensoren. Als ein Beispiel sind in der Figur 5 ein Positionssensor 204 und ein Geschwindigkeits- und/oder Beschleunigungssensor in vertikaler Richtung 205 und in horizontaler Richtung 206 illustriert. Beispiele für die Sensoren 204, 205 und 206 sind Geophonsensoren und/oder piezo-elektrische Sensoren. Beispiele für die Aktoren oder Kraftaktoren 207 und 208 stellen Lorentzmotoren und/oder Piezoaktoren dar.
Es ist dem Fachmann ersichtlich, dass die beschriebenen Ausführungsformen beispielhaft zu verstehen sind.

### Bezugszeichenliste

- 1: Elektrisch geladene Teilchen oder Elektronen oder Elektronenstrahl

- 10: Vorrichtung zum Bereitstellen von elektrisch geladenen Teilchen oder Elektronenmikroskop
- 11: Elektronenquelle oder Elektronenkanone
- 12: Erste Blende zur Strahlüberwachung
- 13: Kondensorlinse
- 14: Ventil
- 15: Magnetische oder elektrische Ablenkeinrichtung
- 16: Magnetische oder elektrische Ablenkeinrichtung
- 17: Objektivlinse
- 18: Objektivblende oder letzte Blende

- 20: Kammer oder Vakuumkammer für die Probe
- 21: Kammerwand
- 21a: Außenseite der Kammerwand
- 21b: Innenseite der Kammerwand
- 22: Ausnehmung oder Hohlraum in der Kammerwand
- 23: Probenhalter
- 24: Manipulator

- 30: Probe oder Target

- 40: System zur Magnetfeldkompensation
- 41: Spule oder Kompensationsspule oder Spulenpaar oder Kompensationsspulenpaar
- 42: Sensor zum Erfassen eines Magnetfelds
- 43: Einrichtung zum Regeln und/oder Steuern des Stroms in der Spule
- 44: Stromversorgung
- 100: Anordnung zum Abbilden, Untersuchen und/oder Bearbeiten einer Probe

- 200: Schwingungsisolationssystem
- 201: Isolierte Masse oder Basismasse oder isolierter Tisch
- 202: Pneumatischer Isolator oder Schwingungsisolator oder Luftlager mit Ventil
- 203: Boden oder Unterlage
- 204: Positionssensor
- 205: Geschwindigkeitssensor oder Beschleunigungssensor in vertikaler Richtung
- 206: Geschwindigkeitssensor oder Beschleunigungssensor in horizontaler Richtung
- 207: Aktuator mit vertikaler Wirkrichtung
- 208: Aktuator mit horizontaler Wirkrichtung

## Patentansprüche

1. Anordnung (100) zum Abbilden, Untersuchen und/oder Bearbeiten einer Probe (30) mittels elektrisch geladener Teilchen (1), umfassend
- eine Vorrichtung (10) zum Bereitstellen von elektrisch geladenen Teilchen (1) und zum Führen der elektrisch geladenen Teilchen auf eine in einer Kammer (20) angeordnete Probe (30),
wobei die Kammer (20) einen Probehalter (23) umfasst, auf welchem eine Probe (30) so positionierbar ist, dass diese mittels der durch die Vorrichtung (10) bereitstellbaren Teilchen (1) abgebildet, untersucht und/oder bearbeitet werden kann, und
- ein System (40) zur Magnetfeldkompensation in zumindest einer Raumrichtung (X, Y, Z) mit wenigstens einer Kompensationsspule (41), welche durch wenigstens eine Windung eines Leiters bereitgestellt ist, so dass in einem durch die wenigstens eine Kompensationsspule (41) erzeugten Kompensationsvolumen innerhalb der Kammer (20) ein Magnetfeld so bereit gestellt wird, dass entlang eines Abschnitts einer Flugbahn der elektrisch geladenen Teilchen ein magnetisches Störfeld kompensiert wird, wobei
wenigstens eine Wand (21) der Kammer (20) zumindest abschnittsweise einen Aufnahmebereich (21a, 21b, 22) für zumindest einen Abschnitt der Kompensationsspule (41) aufweist.

2. Anordnung (100) nach vorstehendem Anspruch, **dadurch gekennzeichnet, dass** der Aufnahmebereich (21a, 21b) durch eine Außenseite und/oder eine Innenseite der Kammerwand (21) bereitgestellt ist und die Kompensationsspule (41) zumindest abschnittsweise auf der Außenseite und/oder der Innenseite der Kammerwand (21) angeordnet ist.

3. Anordnung (100) nach einem der beiden vorstehenden Ansprüche, **dadurch gekennzeichnet, dass** der Aufnahmebereich (22) durch eine zumindest sich abschnittsweise in der Kammerwand (21) erstreckende Ausnehmung bereitgestellt ist.

4. Anordnung (100) nach einem der vorstehenden Ansprüche, **dadurch gekennzeichnet, dass** die Ausnehmung (22) als ein Hohlraum in der Kammerwand (21) ausgeführt ist.

5. Anordnung (100) nach einem der vorstehenden Ansprüche, **dadurch gekennzeichnet, dass** jeder Raumrichtung (X, Y, Z) wenigstens eine Kompensationsspule (41) zugeordnet ist, so dass ein magnetisches Störfeld in den drei Raumrichtungen (X, Y, Z) kompensierbar ist.

6. Anordnung (100) nach einem der vorstehenden Ansprüche, **dadurch gekennzeichnet, dass** jeder Raumrichtung (X, Y, Z) wenigstens ein Kompensationsspulenpaar zugeordnet ist, so dass ein magnetisches Störfeld in den drei Raumrichtungen (X, Y, Z) kompensierbar ist.

7. Anordnung (100) nach vorstehendem Anspruch, **dadurch gekennzeichnet, dass** eine einzelne Kompensationsspule (41) des Kompensationsspulenpaars oder das Kompensationsspulenpaar mittels des Systems (40) zur Magnetfeldkompensation ansteuerbar ist.

8. Schwingungsisolationssystem (200) mit wenigstens einer schwingungsisoliert gelagerten Anordnung (100) nach einem der vorstehenden Ansprüche.

9. Verfahren zum Abbilden, Untersuchen und/oder Bearbeiten einer Probe (30) mittels elektrisch geladener Teilchen (1), indem
die elektrisch geladenen Teilchen (1) von einer Vorrichtung (10) bereitgestellt und auf eine in einer Kammer (20) angeordnete Probe (30) geführt werden, wobei wenigstens eine Wand (21) der Kammer (20) zumindest abschnittsweise einen Aufnahmebereich (21a, 21b, 22) für zumindest einen Abschnitt einer Kompensationsspule (41) aufweist, und wobei
in einem durch die wenigstens eine Kompensationsspule (41) erzeugten Kompensationsvolumen ein Magnetfeld so bereitgestellt wird, dass entlang eines Abschnitts einer Flugbahn der Teilchen (1) ein magnetisches Störfeld kompensierbar ist, wobei
das Kompensationsvolumen in einem Bereich nach einer Fokussierung und/oder Filterung der elektrisch geladenen Teilchen (1) bereitgestellt wird und wobei das Kompensationsvolumen auf einen Bereich innerhalb der Kammer (20) beschränkt wird.

## Claims

1. An arrangement (100) for imaging, examining and/or processing a sample (30) using electrically charged particles (1), comprising
- a device (10) for providing and directing electrically charged particles (1) to a sample (30) arranged inside a chamber (20);
- wherein the chamber (20) comprises a sample holder (23) on which a sample (30) is positionable such that it can be imaged, examined and/or processed using the particles (1) providable by said device (10); and
- a system (40) for magnetic field compensation in at least one spatial direction (X, Y, Z), including at least one compensation coil (41) which is provided by at least one turn of a conductor, so that, in a compensation volume inside said chamber (20) generated by at the least one compensation coil (41), a magnetic field is provided such that a magnetic interference field can be compensated for along a portion of a trajectory of the electrically charged particles,
wherein
at least one wall (21) of said chamber (20) has at least one accommodation area (21a, 21b, 22), at least in sections thereof, for at least one portion of said compensation coil (41).

2. The arrangement (100) as claimed in the preceding claim, wherein said accommodation area (21a, 21b) is provided by an outer surface and/or an inner surface of the chamber wall (21), and wherein said compensation coil (41) is arranged, at least partially, on the outer surface and/or the inner surface of the chamber wall (21).

3. The arrangement (100) as claimed in any of the two preceding claims, wherein said accommodation area (22) is provided by a recess which at least partially extends into the chamber wall (21).

4. The arrangement (100) as claimed in any of the preceding claims, wherein said recess (22) is formed as a cavity in the chamber wall (21).

5. The arrangement (100) as claimed in any of the preceding claims, wherein each spatial direction (X, Y, Z) has associated therewith at least one compensation coil (41), so that a magnetic interference field can be compensated for in the three spatial directions (X, Y, Z).

6. The arrangement (100) as claimed in any of the preceding claims, wherein each spatial direction (X, Y, Z) has associated therewith at least one pair of compensation coils, so that a magnetic interference field can be compensated for in the three spatial directions (X, Y, Z).

7. The arrangement (100) as claimed in the preceding claim, wherein said system (40) for magnetic field compensation is adapted to excite one single compensation coil (41) of the pair of compensation coils, or said pair of compensation coils.

8. A vibration isolation system (200), comprising at least one arrangement (100) as claimed in any of the preceding claims mounted in vibration-isolated manner.

9. A method for imaging, examining and/or processing a sample (30) using electrically charged particles (1), wherein
the electrically charged particles (1) are provided by a device (10) and are directed to a sample (30) arranged inside a chamber (20); wherein at least one wall (21) of said chamber (20) has at least one accommodation area (21a, 21b, 22), at least in sections thereof, for at least one portion of said compensation coil (41) and wherein
in a compensation volume generated by at the least one compensation coil (41), a magnetic field is provided such that a magnetic interference field can be compensated for along a portion of a trajectory of said particles (1); wherein
said compensation volume is provided in a region following a focusing of the electrically charged particles (1) and wherein the compensation volume is limited to an area inside said chamber (20).

## Revendications

1. Ensemble (100) de reproduction, d'analyse et/ou de traitement d'un échantillon (30) au moyen de particules (1) chargées électriquement, comprenant :
- un dispositif (10) destiné à fournir des particules (1) chargées électriquement et à guider les particules chargées électriquement sur un échantillon (30) agencé dans une chambre (20),
la chambre (20) comportant un porte-échantillon (23) sur lequel un échantillon (30) peut être positionné de manière à pouvoir être reproduit, analysé et/ou traité au moyen des particules (1) pouvant être fournies par le dispositif (10), et
- un système (40) de compensation du champ magnétique dans au moins une direction spatiale (X, Y, Z) comprenant au moins une bobine de compensation (41), laquelle est fournie par au moins un enroulement d'un conducteur, de sorte qu'un champ magnétique est fourni à l'intérieur de la chambre (20) dans un volume de compensation produit par ladite au moins une bobine de compensation (41), de telle sorte qu'un champ parasite magnétique est compensé le long d'une partie d'une trajectoire des particules chargées électriquement,
au moins une paroi (21) de la chambre (20) comprenant au moins en partie une zone de réception (21a, 21b, 22) pour au moins une partie de la bobine de compensation (41).

2. Ensemble (100) selon la revendication précédente, **caractérisé en ce que** la zone de réception (21a, 21b) est fournie par une face extérieure et/ou une face intérieure de la paroi (21) de la chambre et la bobine de compensation (41) est agencée au moins en partie sur la face extérieure et/ou la face intérieure de la paroi (21) de la chambre.

3. Ensemble (100) selon l'une des deux revendications précédentes, **caractérisé en ce que** la zone de réception (22) est fournie par un évidement s'étendant au moins en partie dans la paroi (21) de la chambre.

4. Ensemble (100) selon l'une quelconque des revendications précédentes, **caractérisé en ce que** l'évidement (22) est réalisé sous la forme d'une cavité dans la paroi (21) de la chambre.

5. Ensemble (100) selon l'une quelconque des revendications précédentes, **caractérisé en ce qu'**au moins une bobine de compensation (41) est associée à chaque direction spatiale (X, Y, Z), de sorte qu'un champ parasite magnétique dans les trois directions spatiales (X, Y, Z) peut être compensé.

6. Ensemble (100) selon l'une quelconque des revendications précédentes, **caractérisé en ce qu'**au moins une paire de bobines de compensation est associée à chaque direction spatiale (X, Y, Z), de sorte qu'un champ parasite magnétique dans les trois directions spatiales (X, Y, Z) peut être compensé.

7. Ensemble (100) selon la revendication précédente, **caractérisé en ce qu'**une seule bobine de compensation (41) de la paire de bobines de compensation ou la paire de bobines de compensation peut être commandée au moyen du système (40) pour la compensation du champ magnétique.

8. Système d'isolation des vibrations (200) comprenant au moins un ensemble (100) selon l'une quelconque des revendications précédentes monté de manière à être isolé des vibrations.

9. Procédé de reproduction, d'analyse et/ou de traitement d'un échantillon (30) au moyen de particules (1) chargées électriquement, selon lequel :
les particules (1) chargées électriquement sont fournies par un dispositif (10) et guidées sur un échantillon (30) agencé dans une chambre (20), au moins une paroi (21) de la chambre (20) comprenant au moins en partie une zone de réception (21a, 21b, 22) pour au moins une partie d'une bobine de compensation (41), et où
un champ magnétique est fourni dans un volume de compensation produit par ladite au moins une bobine de compensation (41), de telle sorte qu'un champ parasite magnétique peut être compensé le long d'une partie d'une trajectoire des particules (1), où
le volume de compensation est fourni dans une zone après une focalisation et/ou un filtrage des particules (1) chargées électriquement et où le volume de compensation est limité à une zone située à l'intérieur de la chambre (20).
